# FASCICULE DE BREVET EUROPEEN

(11) **EP 3 185 294 B1**
(45) Date de publication et mention de la délivrance du brevet: **08.04.2020**
(21) Numéro de dépôt: 16205880.4
(22) Date de dépôt: 21.12.2016
(51) Int. Cl.: H01L 25/16, H01L 27/15, H01L 31/173, H05B 33/08, H01L 33/50, H01L 33/60, H01L 31/0352, H01L 31/0232

(54) **DISPOSITIF OPTOELECTRONIQUE D'EMISSION DE LUMIERE**
OPTOELEKTRONISCHE VORRICHTUNG ZUR LICHTABGABE
OPTOELECTRONIC LIGHT-EMITTING DEVICE

(30) Priorité: 23.12.2015 FR 1563251
(43) Date de publication de la demande: 28.06.2017
(73) Titulaire: Commissariat à l'énergie atomique et aux énergies alternatives, 75015 Paris (FR)
(72) Inventeur: ROBIN, Ivan-Christophe, 38000 GRENOBLE (FR); BONO, Hubert, 38000 GRENOBLE (FR); DESIERES, Yohan, 38250 LANS EN VERCORS (FR)
(74) Mandataire: GIE Innovation Competence Group

(56) Documents cités:
- US-A- 4 284 884
- US-A1- 2003 030 808
- US-A1- 2003 076 056
- US-A1- 2009 040 755
- US-A1- 2010 001 300
- US-A1- 2010 264 835
- US-A1- 2012 062 113
- US-A1- 2013 207 156
- US-A1- 2014 184 062
- US-B2- 6 617 795

## Description

### DOMAINE TECHNIQUE

L'invention porte sur un dispositif optoélectronique d'émission de lumière comportant au moins une diode électroluminescente recouverte d'un matériau à particules photoluminescentes. L'invention trouve une application notamment dans les systèmes d'éclairage dont on souhaite contrôler ou ajuster le spectre d'émission associé aux diodes électroluminescentes.

### ÉTAT DE LA TECHNIQUE ANTÉRIEURE

Il existe des dispositifs optoélectroniques comportant des diodes électroluminescentes dont la surface d'émission est recouverte par un matériau photoluminescent. C'est notamment le cas des systèmes d'éclairage émettant une lumière blanche.

Les diodes électroluminescentes sont formées d'un empilement de couches semiconductrices adapté à émettre un rayonnement lumineux, par exemple bleu ou ultraviolet. Les couches semiconductrices sont généralement réalisées à base d'un matériau comprenant des éléments de la colonne III et de la colonne V du tableau périodique, tel qu'un composé III-N, notamment le nitrure de gallium (GaN), le nitrure d'indium et de gallium (InGaN) ou le nitrure d'aluminium et de gallium (AlGaN).

En fonction des caractéristiques recherchées du spectre d'émission du dispositif optoélectronique, une couche de matériau photoluminescent recouvre la surface d'émission de la diode électroluminescente, le matériau photoluminescent étant adapté à convertir au moins une partie du rayonnement lumineux dit d'excitation émis par la diode électroluminescente, en un rayonnement lumineux dit de photoluminescence de plus grande longueur d'onde. Le matériau photoluminescent peut comporter des particules dispersées dans une matrice liante, par exemple des particules de grenat d'yttrium et d'aluminium activé par l'ion cérium, appelé YAG:Ce.

Il existe cependant un besoin pour contrôler les caractéristiques du spectre d'émission du dispositif optoélectronique et notamment de celui associé à la diode électroluminescence elle-même. Il existe également un besoin d'un dispositif optoélectronique présentant une structure monolithique qui autorise une forte densité de diodes électroluminescentes.

Les documents US2012/062113-A1, US2009/040755-A1, US2010/001300-A1, US2010/264835-A1 et US 2013/207156-A1 représentent également l'état de la technique antérieure et proposent des dispositfs optoélectroniques avec diode électroluminescente et photodiode.

### EXPOSÉ DE L'INVENTION

L'invention a pour objectif de remédier au moins en partie aux inconvénients de l'art antérieur, et plus particulièrement de proposer un dispositif optoélectronique d'émission de lumière, comprenant :
- au moins une diode électroluminescente présentant une surface d'émission, apte à émettre un rayonnement lumineux dit d'excitation ; et
- un matériau photoluminescent qui revêt la surface d'émission, le matériau photoluminescent comportant des particules photoluminescentes adaptées à convertir au moins en partie ledit rayonnement lumineux d'excitation au travers de la surface d'émission en un rayonnement lumineux dit de photoluminescence.

Selon l'invention, le dispositif optoélectronique comporte au moins une photodiode, adjacente à la diode électroluminescente, présentant une surface de réception revêtue par le matériau photoluminescent, et adaptée à détecter au moins une partie du rayonnement d'excitation et/ou du rayonnement de photoluminescence provenant du matériau photoluminescent au travers de la surface de réception.

Certains aspects préférés mais non limitatifs de cette source sont les suivants :
La diode électroluminescente et la photodiode peuvent présenter chacune une structure mesa, la surface d'émission et la surface de réception étant sensiblement coplanaires.

La diode électroluminescente et la photodiode peuvent comporter chacune une première portion semiconductrice dopée selon un premier type de conductivité et une seconde portion semiconductrice dopée selon un second type de conductivité opposé au premier type de conductivité, les premières portions et secondes portions semiconductrices étant respectivement sensiblement coplanaires et réalisées en un matériau de même composition.

La première portion semiconductrice dopée de la diode électroluminescente et celle de la photodiode présentent un flanc latéral comportant une surface de décrochement formée par une seconde partie de la première portion semiconductrice dopée vis-à-vis d'une première partie de celle-ci.

Un élément de connexion électrique latéral peut s'étendre entre la diode électroluminescente et la photodiode adjacente, de manière à être au contact électrique avec la surface de décrochement de la première portion semiconductrice dopée, l'élément de connexion latéral étant en outre électriquement isolé de la seconde portion semiconductrice dopée et de zones actives situées entre les première et seconde portions semiconductrices dopées par des portions diélectriques recouvrant des flancs latéraux des structures mesa. La diode électroluminescente et la photodiode peuvent comporter chacune une zone active située entre les première et seconde portions semiconductrices dopées, les zones actives étant sensiblement coplanaires et réalisées en un matériau de même composition.

Les zones actives de la diode électroluminescente et de la photodiode peuvent comporter chacune au moins un premier puits quantique, ledit premier puits quantique de la zone active de la diode électroluminescente étant adapté à émettre le rayonnement lumineux d'excitation à une longueur d'onde dite d'excitation.

Les zones actives de la diode électroluminescente et de la photodiode peuvent comporter chacune au moins un second puits quantique, ledit puits quantique de la zone active de la photodiode étant adapté à détecter le rayonnement lumineux de photoluminescence.

Le second puits quantique peut être situé entre une première portion semiconductrice dopée de type N et le premier puits quantique.

Un filtre optique peut être disposé entre le matériau photoluminescent et la surface de réception de la photodiode, le filtre étant adapté à transmettre le rayonnement de photoluminescence et à bloquer une transmission du rayonnement d'excitation.

Le dispositif optoélectronique peut comporter en outre un dispositif de commande adapté à modifier le rayonnement lumineux d'excitation émis par la diode électroluminescente à partir d'un signal de détection du rayonnement lumineux détecté par la photodiode.

Le dispositif optoélectronique peut comporter des contacts électriques adaptés à polariser la diode électroluminescente et la photodiode, les contacts électriques étant situés au niveau d'une face de la diode électroluminescente et de la photodiode opposée à la surface d'émission et à la surface de réception. La face opposée peut être la face arrière d'une puce optoélectronique qui comporte la diode électroluminescente et la photodiode. Les contacts électriques peuvent être des éléments de connexion électrique disposés en contact avec des portions conductrices qui sont en contact avec les secondes portions dopées des diodes, et des éléments de connexion électrique disposés en contact avec des éléments de connexion latéraux qui sont en contact avec les premières portions dopées des diodes.

L'invention porte également sur un procédé de fabrication d'un dispositif optoélectronique d'émission de lumière selon l'une quelconque des caractéristiques précédentes, dans lequel :
i) on réalise au moins une diode électroluminescente présentant une surface d'émission et apte à émettre un rayonnement lumineux dit d'excitation, et au moins une photodiode adjacente présentant une surface de réception ;
ii) on recouvre les surfaces d'émission et de réception d'un matériau photoluminescent comportant des particules photoluminescentes adaptées à convertir au moins en partie ledit rayonnement lumineux d'excitation au travers de la surface d'émission en un rayonnement lumineux dit de photoluminescence.

L'étape i) peut comporter les sous-étapes dans lesquelles :
a. on réalise un empilement de couches comprenant une première couche semiconductrice dopée et une seconde couche semiconductrice dopée entre lesquelles est interposée une couche active comportant au moins un puits quantique ;
b. on grave l'empilement de couches de manière à former une structure mesa destinée à former une diode électroluminescente et une structure mesa destinée à former une photodiode adjacente, chaque structure mesa étant formée d'un empilement d'une première portion semiconductrice dopée, d'une zone active et d'une seconde portion semiconductrice dopée, la première portion semiconductrice dopée desdites structures mesa comportant un flanc latéral présentant une surface de décrochement ;
c. on réalise des portions diélectriques recouvrant les flancs latéraux des structures mesa à l'exception des surfaces de décrochement ;
d. on dépose un matériau électriquement conducteur entre les structures mesa, le matériau conducteur étant en contact de la surface de décrochement de la première portion semiconductrice dopée et électriquement isolé par les portions diélectriques de la zone et de la seconde portion semiconductrice dopée.

On peut réaliser des éléments de connexion électrique adaptés à polariser en direct la diode électroluminescente et en indirect la photodiode à partir de portions électriquement conductrices de polarisation situées sur une face opposée au matériau photoluminescent.

### BRÈVE DESCRIPTION DES DESSINS

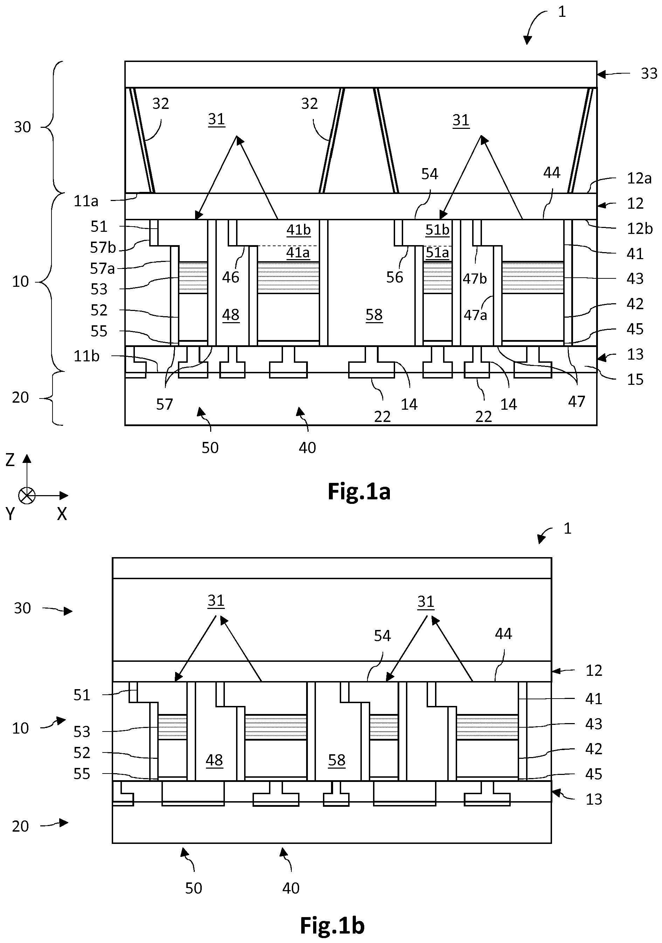

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure la est une vue schématique en coupe d'un dispositif optoélectronique d'émission de lumière selon un mode de réalisation dans lequel le capot comporte des blocs photoluminescents, et la figure 1b est une variante dans laquelle le capot comporte une couche photoluminescente ;
la figure 2a est une vue schématique en coupe d'un dispositif optoélectronique d'émission de lumière selon un autre mode de réalisation adapté à détecter le rayonnement de photoluminescence, et la figure 2b est une vue détaillée de l'empilement de portions semiconductrices de la diode électroluminescente et de la photodiode adjacente d'un tel dispositif optoélectronique ;
les figures 3a à 3h illustrent les étapes d'un procédé de réalisation d'un dispositif optoélectronique selon un autre mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les termes « sensiblement », « approximativement », « environ » s'étendent « à 10 % près ».

L'invention porte sur un dispositif optoélectronique comportant au moins une diode électroluminescente et une photodiode disposée de manière adjacente à celle-ci, la surface d'émission de la diode électroluminescente et la surface de réception de la photodiode étant revêtues d'un matériau photoluminescent comportant des particules photoluminescentes. La photodiode est adjacente à la diode électroluminescente dans la mesure où elle se situe du même côté et au voisinage de celle-ci vis-à-vis du matériau photoluminescent.

La surface d'émission est une surface de la diode électroluminescente au travers de laquelle un rayonnement lumineux dit d'excitation est émis. La surface de réception est une surface de la photodiode au travers de laquelle un rayonnement lumineux incident est reçu et détecté par la photodiode.

Le matériau photoluminescent est un matériau adapté à convertir au moins partiellement un rayonnement lumineux incident, émis par la diode électroluminescente, en un rayonnement lumineux dit de photoluminescence d'une longueur d'onde différente. Les particules sont des éléments d'un matériau photoluminescent, distinctes les unes des autres, dont la forme peut être quelconque, par exemple sphérique, anguleuse, aplatie ou allongée, ou tout autre forme. La taille des particules est ici la plus petite dimension des particules et la taille moyenne est la moyenne arithmétique de la taille des particules.

La figure la est une vue schématique en coupe d'un dispositif optoélectronique d'émission de lumière selon un mode de réalisation.

On définit ici et pour la suite de la description un repère orthonormé tridimensionnel (X,Y,Z), où le plan (X,Y) est sensiblement parallèle au plan des surfaces d'émission et de réception, et où l'axe Z est orienté suivant une direction orthogonale aux surfaces d'émission et de réception.

Le dispositif optoélectronique 1 comporte ici :
a. une première puce de circuit imprimé 10, dite puce optoélectronique, comportant au moins une diode électroluminescente 40 et une photodiode 50 disposée de manière adjacente à celle-ci. La puce optoélectronique 10 comporte ici une matrice de diodes électroluminescentes 40 définissant une matrice de pixels lumineux dont au moins une partie des pixels comporte une photodiode 50.
b. une seconde puce de circuit imprimé 20, dite puce de commande, disposée sur une face dite arrière 11b de la puce électronique 10. La puce de commande 20 comporte des éléments de connexion permettant de polariser les diodes électroluminescentes 40 et les photodiodes 50.
c. un capot 30, disposé sur une face dite avant 11a de la puce optoélectronique 10, opposée à la face arrière 11b, et comportant le matériau à particules photoluminescentes.

La puce optoélectronique 10 comporte une pluralité de diodes électroluminescentes 40 et de photodiodes 50 formées chacune d'un empilement d'une première et d'une seconde portions semiconductrices dopées, entre lesquelles se situe une zone active. La zone active est la région d'une diode où un rayonnement lumineux est émis (dans le cas d'une diode électroluminescence) ou détecté (dans le cas d'une photodiode).

Les diodes électroluminescentes 40 et les photodiodes 50 forment des structures mesa sensiblement coplanaires les unes aux autres. Par structure mesa, on entend une structure formée d'un empilement de couches ou portions semiconductrices sensiblement planes dont la zone active est en saillie au-dessus d'un substrat de croissance à la suite d'une étape de gravure. La structure des diodes électroluminescentes et des photodiodes peut être identique ou similaire à la structure décrite dans la publication de Fan et al intitulée III-nitride micro-emetter arrays development and applications, J. Phys. D: Appl. Phys. 41 (2008) 094001. En variante, et de manière préférée, elle peut être identique ou similaire à la structure décrite dans la demande de brevet FR1456085 déposée le 27/06/2014 dont le texte est considéré comme faisant partie intégrante de la présente description. Les structures mesa sont sensiblement coplanaires dans le sens où les portions semiconductrices des diodes électroluminescentes et celles des photodiodes sont mutuellement coplanaires.

La diode électroluminescente 40 comprend un empilement formé d'une première portion semiconductrice 41 dopée d'un premier type de conductivité, par exemple de type N, et d'une seconde portion semiconductrice 42 dopée d'un second type de conductivité opposé au premier type, par exemple de type P entre lesquelles est intercalée une zone active 43 dite émissive au niveau de laquelle est généré le rayonnement lumineux de la diode. Une face de la première portion 41 dopée N, opposée à la zone active 43, forme une surface d'émission 44 au travers de laquelle est émis le rayonnement lumineux émis.

La photodiode 50 comprend un empilement formé d'une première portion semiconductrice 51 dopée d'un premier type de conductivité, par exemple de type N, et d'une seconde portion semiconductrice 52 dopée d'un second type de conductivité opposé au premier type, par exemple de type P, entre lesquelles est intercalée une zone active 53 dite de détection au niveau de laquelle est détecté un rayonnement lumineux incident reçu. Une face de la première portion 51 dopée N, opposée à la zone active 53, forme une surface de réception 54 au travers de laquelle est reçu un rayonnement lumineux incident.

Dans cet exemple, chaque portion semiconductrice 41, 42, 43 des diodes électroluminescentes 40 est respectivement coplanaire à celle 51, 52, 53 des photodiodes 50, et présentent une épaisseur et une composition sensiblement identiques. Plus précisément, les premières portions 41 dopées N des diodes électroluminescentes 40 sont coplanaires à celles 51 des photodiodes 50, et présentent une épaisseur et une composition sensiblement identiques. Par matériaux de même composition, on entend des matériaux formés d'éléments de la classification périodique selon une proportion identique. Il en est de même pour les portions dopées P 42, 52 et pour les zones actives 43, 53. Ainsi, les épaisseurs des diodes électroluminescentes et des photodiodes sont sensiblement identiques. Par ailleurs, la surface d'émission 44 et la surface de réception 54 sont sensiblement coplanaires. Chaque diode électroluminescente 40 et photodiode 50 comporte en outre une portion électriquement conductrice 45, 55 au contact d'une face de la seconde portion 42, 52 dopée (ici de type P) opposée à la zone active 43, 53. L'épaisseur de la portion conductrice 45, 55 peut être comprise entre 3nm et 500nm. Les portions conductrices 45, 55 sont de préférence sensiblement coplanaires.

Chaque diode électroluminescente 40 et photodiode 50 présente une structuration de la première portion 41, 51 dopée N formant un décrochement au niveau d'un flanc latéral se traduisant par un élargissement des dimensions latérales dans le plan (X,Y). Plus précisément, chaque première portion 41, 51 dopée N comporte une première partie 41a, 51a, située entre la zone active 43, 53 et une seconde partie 41b, 51b, dont les dimensions latérales sont sensiblement identiques à celles de la zone active 43, 53. Elle comporte également une seconde partie 41b, 51b, dont la face opposée à la première partie 41a, 51a forme la surface d'émission 44 ou de réception 54, dont les dimensions latérales sont supérieures à celles de la première partie 41a, 51a au niveau d'un flanc latéral. Ainsi, la première portion 41, 51 dopée N des diodes 40, 50 comporte une surface de décrochement 46, 56 qui s'étend de manière sensiblement orthogonale à l'axe Z et qui relie les flancs latéraux des premières parties 41a, 51a et secondes parties 41b, 51b. Par ailleurs, la zone active 43, 53 et la seconde portion 42, 52 dopée P des diodes 40, 50 comportent des flancs latéraux qui s'étendent continûment suivant l'axe Z. Les dimensions latérales de la deuxième partie 41b, 51b de la première portion 41, 51 dopée N est supérieure d'au moins 1% à celles de la première partie 41a, 51a. Par exemple, pour une largeur de la première partie 41a, 51a de la portion dopée N de 80µm, la largeur de la deuxième partie 41b, 51b peut être de 85µm.

Les diodes électroluminescentes 40 et les photodiodes 50 peuvent présenter une épaisseur comprise entre 100nm et 50µm, l'épaisseur de la première portion 41, 51 dopée N peut être comprise entre 50nm et 20µm, celle de la zone active 43, 53 peut être comprise entre 10nm et 500nm, et celle de la seconde portion 42, 52 dopée P peut être comprise entre 50nm et 20µm. Les dimensions latérales des diodes, mesurées au niveau des surfaces d'émission et de réception, peuvent être comprises entre 500nm et quelques millimètres, selon les applications visées. De préférence, les dimensions latérales des diodes électroluminescentes sont supérieures à celles des photodiodes.

Les diodes électroluminescentes et les photodiodes peuvent être réalisées à base d'un matériau semiconducteur III-V, c'est-à-dire comprenant principalement au moins un élément de la colonne III et un élément de la colonne V du tableau périodique. Les diodes peuvent notamment être réalisées à base d'un composé III-N, tel que par exemple le GaN, l'InGaN, l'AlGaN, l'AlN, l'InN, l'AlInGaN. Les zones actives peuvent comprendre au moins un puits quantique réalisé à base d'un matériau semiconducteur présentant une énergie de bande interdite inférieure à celle des portions dopées. A titre d'exemple, les portions dopées sont réalisées en GaN et la zone active comporte une alternance de couches semiconductrices intrinsèques (non intentionnellement dopées) en GaN et d'au moins un puits quantique à base d'InGaN. La diode électroluminescente peut être adaptée à émettre une lumière bleue, c'est-à-dire dont le spectre d'émission présente un pic d'intensité compris entre 440nm et 490nm environ, et la photodiode est ici adaptée à détecter la lumière bleue émise par la diode et reçue au travers de la surface de réception.

Les flancs latéraux des diodes sont revêtus d'une portion diélectrique 47, 57, à l'exception des surfaces de décrochement 46, 56. Plus précisément, les flancs latéraux ne comportant pas de décrochement sont recouverts de manière continue d'une portion diélectrique 47, 57. Les flancs latéraux comportant un décrochement sont revêtus d'une portion diélectrique en deux parties : une première partie 47a, 57a qui recouvre les flancs latéraux de la portion 42, 52 dopée P, de la zone active 43, 53 et de la première partie 41a, 51a de la portion 41, 51 dopée N ; et une seconde partie 47b, 57b, distincte de la première, qui recouvre les flancs latéraux de la seconde partie 41b, 51b de la portion 41, 51 dopée N. Ainsi, les surfaces de décrochement 46, 56 ne sont pas revêtues d'une portion diélectrique 47, 57. La portion diélectrique 47, 57 recouvre en outre les flancs latéraux de la portion conductrice 45, 55.

La puce optoélectronique comporte en outre des éléments 48, 58 de connexion électrique, dits latéraux, intercalés entre les diodes électroluminescentes 40 et les photodiodes 50 adjacentes, qui s'étendent entre les faces avant 11a et arrière 11b de la puce optoélectronique. Chaque diode électroluminescente 40 comporte ainsi un élément de connexion latéral 48 qui s'étend entre la portion diélectrique 47a, 47b située au niveau du décrochement 46 d'une part, et la portion diélectrique 57 de la photodiode 50 en regard d'autre part. L'élément de connexion latéral 48 est donc électriquement isolé de la zone active 43 et de la portion 42 dopée P de la diode électroluminescente 40 d'une part, et de la photodiode 50 en regard d'autre part. Il est cependant en contact électrique avec la portion 41 dopée N de la diode électroluminescente 40 au niveau de la surface de décrochement 46, de manière à pouvoir porter la portion 41 dopée N à un potentiel électrique donné. De manière similaire, chaque photodiode 50 comporte un élément de connexion dit latéral 58 qui s'étend entre la portion diélectrique 57a, 57b située au niveau du décrochement 56 d'une part, et la portion diélectrique 47 de la diode électroluminescente 40 en regard. L'élément de connexion latéral 58 est donc électriquement isolé de la zone active 53 et de la portion 52 dopée P de la photodiode d'une part, et de la diode électroluminescente 40 en regard d'autre part. Il est cependant en contact électrique avec la portion 51 dopée N de la photodiode au niveau de la surface de décrochement 56, de manière à pouvoir porter cette portion 51 dopée N à un potentiel électrique donné (de signe opposé à celui de l'élément de connexion latéral de la diode électroluminescente). A noter que les éléments de connexion latéraux 48, 58 sont électriquement isolés des portions conductrices 45, 55 par les portions diélectriques 47, 57. L'épaisseur et le matériau des portions diélectriques 47, 57 sont choisis de manière à obtenir un courant de fuite acceptable entre la portion conductrice et les éléments de connexion latéraux. L'épaisseur peut être de l'ordre de quelques nanomètres, par exemple être comprise entre 3nm et 5nm en fonction du matériau diélectrique utilisé.

Dans cet exemple, le dispositif optoélectronique comporte une couche diélectrique 12 (facultative) intercalée entre les diodes électroluminescentes et photodiodes d'une part et le capot 30 à matériau photoluminescent d'autre part. Elle est réalisée en matériau diélectrique, par exemple en Si₃N₄, de manière à éviter tout court-circuit entre les diodes et les éléments de connexion latéraux correspondant, et peut améliorer l'extraction lumineuse. L'épaisseur de la couche diélectrique 12 est par exemple comprise entre 500nm et 50µm, de préférence entre 1µm et 5µm. Elle comporte une face avant 12a et une face arrière 12b opposée. Les diodes électroluminescentes 40 et les photodiodes 50 sont au contact de la face arrière 12b de la couche diélectrique au niveau des surfaces d'émission et de réception respectives. La face avant 12a peut présenter des motifs en relief (non représentés) situés en regard des surfaces d'émission de manière à améliorer l'extraction du rayonnement lumineux émis par les diodes électroluminescentes, et éventuellement en regard des surfaces de réception.

Dans cet exemple, le dispositif optoélectronique comporte en outre une couche de raccord électrique 13 (facultative) intercalée entre les diodes 40, 50 et la puce de commande 20, facilitant la connexion électrique entre la puce optoélectronique et la puce de commande. La couche de raccord 13 comporte ainsi des éléments de connexion électrique 14 assurant la connexion entre les éléments de connexion latéraux 48, 58 avec des portions conductrices 22 de la puce de commande d'une part, et des éléments de connexion 14 assurant la connexion entre les portions conductrices 45, 55 avec d'autres portions conductrices 22 de la puce de commande. Les éléments de connexion 14 sont électriquement isolés les uns des autres par un matériau diélectrique 15. La couche de raccord 13 présente une épaisseur sensiblement constante, et une face opposée aux diodes forme la face arrière 11b de la puce optoélectronique.

Le dispositif optoélectronique d'émission de lumière comporte en outre une puce de commande 20 assemblée à la puce optoélectronique au niveau de la face arrière 11b. La puce de commande assure notamment la connexion électrique des diodes 40, 50 de manière à assurer l'émission lumineuse par les diodes électroluminescentes ainsi que la détection par les photodiodes. Ainsi, les portions conductrices 22 assurent la connexion en direct des diodes électroluminescentes 40 et la connexion en indirect des photodiodes 50. Plus précisément, un premier potentiel électrique négatif est appliqué aux portions 41 dopées N des diodes électroluminescentes par l'intermédiaire des éléments de connexion latéraux 48 et un premier potentiel positif est appliqué aux portions 42 dopées P par les portions conductrices 45. De plus, un second potentiel négatif est appliqué aux portions 52 dopées P des photodiodes par les portions conductrices 55 et un second potentiel positif est appliqué aux portions 51 dopées N par les éléments de connexion latéraux 58. On est ainsi en mesure d'appliquer une différence de potentiels différente aux diodes électroluminescentes et aux photodiodes. La puce de commande peut également comporter les éléments électroniques, de type transistors, assurant la commande d'émission des diodes électroluminescentes et la lecture du signal électrique de détection des photodiodes. Alternativement, elle peut être un composant passif ne comportant essentiellement que des lignes de connexion électrique des portions conductrices jusqu'à des éléments électroniques déportés.

Le dispositif d'émission de lumière peut comporter en outre un dispositif d'asservissement adapté à corréler le signal électrique de commande des diodes électroluminescentes en fonction du signal électrique de détection des photodiodes adjacentes. Il est alors possible d'augmenter ou diminuer l'intensité d'émission des diodes électroluminescentes en fonction de l'intensité du rayonnement lumineux détecté par chaque photodiode adjacente. Ce dispositif d'asservissement peut être situé dans la puce de commande ou être déporté.

Le dispositif d'émission de lumière peut comporter en outre un dispositif d'analyse du signal électrique de détection de la photodiode. Il est alors possible de comparer l'intensité du rayonnement lumineux détecté par rapport à une valeur seuil, et de modifier le signal électrique de commande de la diode électroluminescente en fonction d'un écart à la valeur seuil, voire d'émettre une information à destination d'un utilisateur.

Le dispositif optoélectronique comprend également un capot 30 comportant le matériau photoluminescent 31 à particules photoluminescentes. Le matériau photoluminescent 31 revêt la surface d'émission 44 de la diode électroluminescente et la surface de réception 54 de la photodiode. Par revêtir, on entend recouvrir partiellement ou entièrement une surface. Le matériau photoluminescent revêt ici entièrement les surfaces d'émission et de réception.

Le matériau photoluminescent comporte des particules photoluminescentes adaptées à absorber au moins une partie du rayonnement lumineux d'excitation émis par la diode électroluminescente et à émettre en réponse un rayonnement lumineux de luminescence à une longueur d'onde de luminescence supérieure à la longueur d'onde d'excitation. Le matériau photoluminescent est généralement appelé luminophore (*phosphor,* en anglais). Le matériau photoluminescent peut se présenter sous forme de couche, ou de plot ou bloc. Par couche, on entend un matériau dont l'épaisseur est inférieure à ses dimensions latérales de longueur et de largeur dans le plan (X,Y), par exemple inférieure de 10 fois, 20 fois voire davantage. Par plot ou bloc, on entend un matériau dont ses dimensions latérales de longueur et de largeur sont inférieures à celles d'une couche et dont l'épaisseur peut être de l'ordre de grandeur des dimensions latérales.

A titre purement illustratif, le matériau photoluminescent peut être adapté à émettre dans le vert, c'est-à-dire que le spectre d'émission par photoluminescence présente un pic d'intensité compris entre 495nm et 560nm, et être par exemple réalisé à base de particules de SrSi2O2N2:Eu. Il peut être adapté à émettre dans le jaune, c'est-à-dire que le spectre d'émission par photoluminescence présente un pic d'intensité compris entre 560nm et 580nm, et être par exemple réalisé à base de particules de YAG:Ce. Bien entendu, d'autres matériaux sont possibles ainsi qu'une émission dans l'orange ou dans le rouge. La taille des particules photoluminescentes peut être micrométrique et être comprise entre 1µm et 50µm, la taille moyenne pouvant être de l'ordre de 10µm.

En variante, le matériau photoluminescent peut comporter des particules photoluminescentes monocristallines de taille nanométrique, appelées également nanocristaux semiconducteurs. Les nanocristaux semiconducteurs peuvent être réalisés en séléniure de cadmium (CdSe), en phosphore d'indium (InP), en sulfure de zinc (ZnS), en séléniure de zinc (ZnSe), en tellurure de cadmium (CdTe), en tellurure de zinc (ZnTe), en oxyde de cadmium (CdO), en oxyde de zinc et de cadmium (ZnCdO), en sulfure de zinc et de cadmium (CdZnS), en séléniure de zinc et de cadmium (CdZnSe), en sulfure d'argent et d'indium (AgInS2) et en un mélange d'au moins deux de ces composés, ou encore en tout matériau équivalent. Les particules photoluminescentes présentent alors une taille moyenne comprise entre 0,2nm et 1000nm, par exemple entre 1nm et 100nm, et notamment entre 2nm et 30nm. La taille et/ou la composition des particules photoluminescentes sont choisies en fonction de la longueur d'onde de luminescence désirée. Ainsi, des particules photoluminescentes de CdSe d'une taille moyenne de 3,6nm environ sont adaptées à convertir de la lumière bleue en lumière rouge, et des particules de CdSe d'une taille moyenne de 1,3nm environ sont adaptées à convertir de la lumière bleue en lumière verte.

Les particules photoluminescentes sont de préférence dispersées dans une matrice liante sous forme d'un matériau transparent et optiquement inerte assurant une fonction de liant vis-à-vis des particules photoluminescentes. Par matériau transparent, on entend un matériau qui transmet au moins 50% de la lumière incidente et de préférence au moins 80%. Par optiquement inerte, on entend un matériau qui n'émet pas de lumière en réponse à une absorption de lumière incidente. La matrice peut être en silice ou en un matériau plastique au moins partiellement transparent, notamment en silicone ou en acide polylactique (PLA).

Le matériau photoluminescent présente une épaisseur qui dépend notamment du type de particules photoluminescentes. Dans le cas de particules de taille micrométrique telles que le YAG:Ce, l'épaisseur peut être comprise entre 100µm et 500µm, et être par exemple de l'ordre de 200µm. Dans le cas de particules de taille nanométrique telles que les nanocristaux de CdSe, elle peut être inférieure à 50nm, voire inférieure à 30nm, et être par exemple de l'ordre de 1nm à 5nm.

Sur la figure 1a, le capot 30 comporte plusieurs blocs photoluminescents 31 qui recouvrent chacun une diode électroluminescente 40 et la photodiode 50 adjacente. Chaque bloc photoluminescent 31 est contenu dans un espace prévu dans le capot, délimité par des parois latérales avantageusement inclinées et recouvertes d'un revêtement 32 réfléchissant vis-à-vis des rayonnements lumineux d'émission et de photoluminescence, par exemple un film d'aluminium. L'épaisseur du capot dépend notamment de celle du matériau photoluminescent. Il peut être réalisé en un matériau isolant, semiconducteur ou conducteur, notamment selon que la couche diélectrique d'extraction lumineuse est présente ou non. A titre d'exemple, il est réalisé en silicium. Les dimensions latérales des blocs luminescent sont ajustées aux dimensions latérales, dans le plan (X,Y), d'une paire de diode électroluminescente et de la photodiode adjacente. Elle peut ainsi être comprise, en fonction des applications, entre 2µm et 1mm. Par exemple, elle peut être de l'ordre de 100µm dans le cas d'une application « éclairage » du dispositif d'émission de lumière, et être de l'ordre de 5µm à 20µm dans le cas d'une application « écran » du dispositif d'émission de lumière. Le capot 30 peut comporter en outre une couche ou plaque 33 d'un matériau transparent aux longueurs d'onde d'excitation et de photoluminescence.

En fonctionnement, on applique une tension en direct aux diodes électroluminescentes 40 de manière à ce qu'elles émettent un rayonnement lumineux à une longueur d'onde dite d'excitation, par exemple une lumière bleue dont le spectre d'émission présente un pic d'intensité à 480nm environ. Le rayonnement lumineux est émis en direction du matériau photoluminescent 31 au travers de la surface d'émission 44.

Le matériau photoluminescent 31 convertit au moins une partie du rayonnement incident d'excitation en un rayonnement lumineux de photoluminescence à une seconde longueur d'onde dite de photoluminescence, par exemple en une lumière verte dont le spectre d'émission présente un pic d'intensité à 530nm dans le cas où le matériau photoluminescent comporte des particules de SrSi₂O₂N₂:Eu.

Ainsi, le spectre d'émission du dispositif d'émission de lumière correspond localement à la superposition d'au moins une partie du rayonnement lumineux émis par la diode électroluminescente et non converti par le matériau photoluminescent, et d'au moins une partie du rayonnement lumineux converti par le matériau photoluminescent.

Par ailleurs, on applique une tension en indirect aux photodiodes 50 de manière à ce qu'elles détectent un rayonnement lumineux incident reçu au travers de la surface de réception 54.

Selon l'invention, dans la mesure où le matériau photoluminescent 31 comporte des particules photoluminescentes et recouvre les surfaces d'émission 44 et de réception 55, une partie du rayonnement lumineux d'excitation est diffusé, ou rétrodiffusé, en direction de la surface de réception 54 de la photodiode 50 adjacente. Ainsi, dans la mesure où la zone active 53 de la photodiode 50 est réalisée en un matériau de composition identique à celle de la diode électroluminescente 40, la photodiode est adaptée à détecter au moins une partie du rayonnement d'excitation rétrodiffusé. On lit ensuite le signal électrique de la photodiode issu de la détection du rayonnement lumineux incident.

Lorsque les particules photoluminescentes ont une taille moyenne inférieure à la longueur d'onde d'excitation, comme c'est le cas des nanocristaux semiconducteurs mentionnés précédemment, la diffusion du rayonnement d'excitation en direction de la photodiode adjacente est une diffusion de Rayleigh qui est essentiellement isotrope. Lorsque les particules photoluminescentes ont une taille moyenne supérieure à la longueur d'onde d'excitation, comme c'est le cas par exemple des grains de YAG:Eu, la diffusion est une diffusion de Mie. Dans les deux types de diffusion, la composante rétrodiffusée du rayonnement lumineux est non nulle et peut donc être détectée par la photodiode adjacente.

Ainsi, le dispositif optoélectronique d'émission de lumière présente l'avantage d'émettre de la lumière avec un spectre d'émission qui dépend notamment des propriétés du matériau photoluminescent et du spectre d'émission des diodes électroluminescentes, tout en permettant la détection locale d'une partie de la lumière émise par chacune des diodes électroluminescentes.

On a ainsi un dispositif optoélectronique d'émission de lumière à contrôle intégré et localisé de l'émission des diodes électroluminescentes. La détection par la photodiode adjacente est facilitée dans la mesure où la zone active de détection présente les mêmes propriétés optiques et électroniques que celles de la zone active d'émission.

On a ainsi accès au rayonnement lumineux effectivement émis par les diodes électroluminescentes par la détection effectuée par les photodiodes adjacentes, indépendamment de la conversion de lumière réalisée par les particules photoluminescentes. Ceci est particulièrement avantageux lorsque le dispositif d'émission de lumière comporte une pluralité de blocs photoluminescents adaptés à convertir la lumière d'excitation à différentes longueur d'onde de photoluminescence, par exemple lorsque certains blocs photoluminescents sont adaptés à convertir dans le rouge, d'autres dans le vert, d'autres encore dans le jaune, etc. Ainsi, quelles que soient les longueurs d'onde du rayonnement de photoluminescence des différents blocs, la détection du rayonnement lumineux d'excitation des différentes diodes électroluminescentes est effectuée localement par les photodiodes adjacentes.

Par ailleurs, la structuration mesa coplanaire et avec décrochement des diodes électroluminescentes et des photodiodes permet d'obtenir une haute densité de diodes, avec des dimensions latérales des diodes électroluminescentes et des photodiodes pouvant être de l'ordre de 10µm à 50µm. La connexion électrique des diodes est également facilitée tout en garantissant une bonne isolation électrique entre les éléments de connexion électrique.

Enfin, le dispositif d'émission de lumière comporte des diodes électroluminescentes et des photodiodes intégrées de manière monolithique, pouvant être obtenues de manière simultanée par le procédé de fabrication détaillé plus loin.

La figure 1b illustre un autre mode de réalisation du dispositif d'émission de lumière représenté sur la figure la. Il s'en distingue essentiellement par le capot 30 de matériau photoluminescent d'une part et par la couche de raccord électrique 13 d'autre part.

Dans cet exemple, la puce optoélectronique est similaire à celle représentée sur la figure 1a, à ceci près que des éléments de connexion 22 assurent ici le raccord électrique de l'élément de connexion latéral 48 de la diode électroluminescente ainsi que de la portion conductrice 55 de la photodiode adjacente à la même portion conductrice 22 de la puce de commande 20. L'élément de connexion latéral 48 de la diode électroluminescente 40 est ici disposé entre la diode électroluminescente 40 et la photodiode adjacente 50. Ainsi, la portion 52 dopée P de la photodiode et la portion 41 dopée N de la diode électroluminescente sont portées chacune au même potentiel électrique.

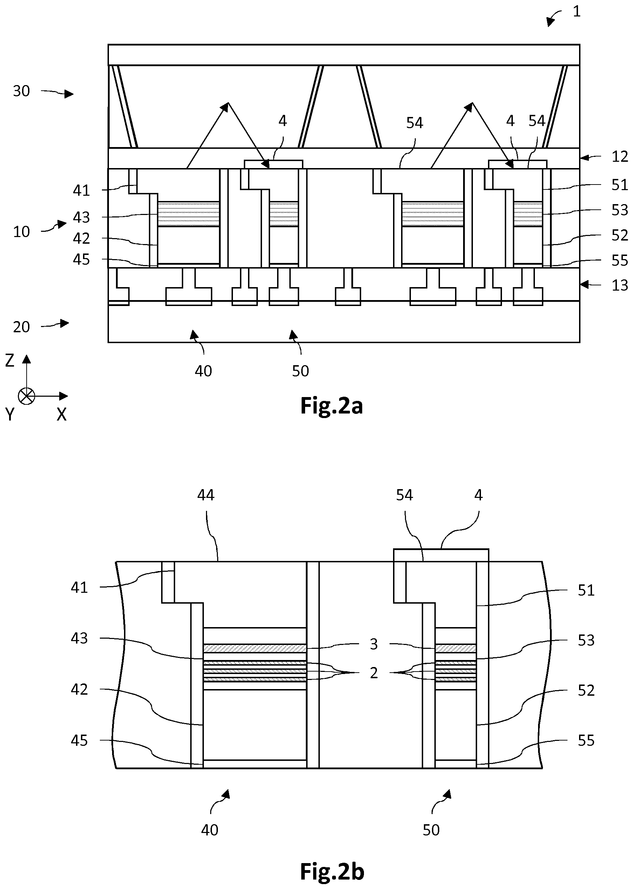

Dans une variante où l'élément de connexion latéral de la photodiode est situé entre la diode électroluminescente et la photodiode adjacente (cf. figure 2a), un élément de connexion peut assurer le raccord électrique de la portion conductrice de la diode électroluminescente et de l'élément de connexion latéral de la photodiode adjacente à la même portion conductrice de la puce de commande. Ainsi, la portion dopée P de la diode électroluminescente et la portion dopée N de la photodiode adjacente sont alors portées chacune au même potentiel électrique.

Par ailleurs, le capot 30 comporte ici une couche d'un matériau 31 à particules photoluminescentes identique ou similaire à celui décrit précédemment. Ainsi, le même matériau recouvre une pluralité de paires de diode électroluminescente et de photodiode adjacente.

Les figures 2a et 2b illustrent un autre mode de réalisation du dispositif optoélectronique d'émission de lumière, qui se distingue de celui illustré sur la figure la essentiellement en ce que le dispositif optoélectronique est adapté à émettre un rayonnement d'excitation par des diodes électroluminescents et à détecter au moins une partie du rayonnement de photoluminescence par les photodiodes adjacentes.

Dans cet exemple, le capot 30 à matériau photoluminescent et la puce de commande 20 sont identiques ou similaires à ceux décrits en référence à la figure la. Les diodes électroluminescentes 40 et les photodiodes 50 présentent une structure mesa coplanaire identique à celle décrite en référence à la figure la.

La zone active 53 des photodiodes est adaptée à détecter le rayonnement lumineux de photoluminescence reçu au travers de la surface de réception 54. Pour cela, comme l'illustre en détail la figure 2b, la zone active 53 comporte au moins un puits quantique 3 réalisé à base d'un matériau semiconducteur présentant une énergie de bande interdite inférieure à celle des portions dopées 51, 52 et permettant de détecter le rayonnement de photoluminescence reçu. Dans la mesure où la longueur d'onde de photoluminescence est supérieure à celle d'excitation, le puits quantique 3 présente une énergie de bande interdite inférieure à celle des puits quantiques 2 adaptés à détecter le rayonnement d'excitation. A titre d'exemple, le puits quantique 3 peut être réalisé en InGaN avec 23% d'indium pour détecter un rayonnement de photoluminescence dans le vert à 530nm environ. En variante, le puits quantique 3 peut être réalisé en InGaN à 30% d'indium pour détecter un rayonnement de photoluminescence dans le rouge à 600nm environ.

Dans la mesure où les zones actives de détection 53 et d'émission 43 présentent la même composition de matériau, le puits quantique 3 de détection de la photoluminescence est également présent dans la zone active 43 de la diode électroluminescente adjacente. Pour ne pas modifier les propriétés d'émission des diodes électroluminescentes, le puits quantique 3 est de préférence situé entre les puits quantiques 2 et la portion 41 dopée N. En effet, la mobilité des trous étant inférieure à celle des électrons, l'émission du rayonnement lumineux a lieu essentiellement dans les puits quantiques 2 situés à proximité de la portion 42 dopée P. Ainsi, le spectre d'émission des diodes électroluminescences n'est pas modifié par la présence du puits quantique de détection de la photoluminescence dans les zones actives émissives.

Dans la zone active 53 de la photodiode adjacente, le puits quantique 3 peut détecter le rayonnement de photoluminescence ainsi que le rayonnement d'excitation. Pour ne détecter que le rayonnement de photoluminescence, il est avantageux qu'un filtre optique 4 soit prévu entre la surface de réception 54 des photodiodes et le matériau photoluminescent 31, de manière à transmettre le rayonnement lumineux de photoluminescence et à bloquer la transmission du rayonnement lumineux d'excitation. Le filtre optique peut être formé, de manière connue, d'un empilement multicouche de matériaux diélectriques tels que, par exemple, du SiN et SiO2.

Ainsi, le dispositif d'émission de lumière présente les avantages mentionnés précédemment tout en étant en mesure de détecter de la lumière de photoluminescence convertie par le matériau photoluminescence au plus près de la diode électroluminescente, dans la mesure où l'émission par photoluminescence est sensiblement isotrope. Dans le cas où le capot comporte des blocs photoluminescents adaptés à émettre à différentes longueurs d'onde, les différentes photodiodes permettent ainsi de détecter l'intensité des différentes composantes du spectre d'émission global du dispositif optoélectronique lui-même. En asservissant le signal de commande des différentes diodes électroluminescentes au signal de détection des photodiodes, il est possible de modifier le spectre d'émission global du dispositif optoélectronique. Par ailleurs, dans le cas où le capot comporte un matériau photoluminescent qui recouvre de manière continue les diodes électroluminescentes et les photodiodes, le dispositif d'émission de lumière permet de détecter la réponse spatiale de photoluminescente du matériau et d'établir ainsi la distribution spatiale ou la cartographie de photoluminescence du matériau.

Par ailleurs, de manière à optimiser le rendement d'émission lumineuse des diodes électroluminescentes, un film d'un matériau réfléchissant (non représenté) revêt la face des portions isolantes des diodes électroluminescentes opposée à la face en contact avec les portions semiconductrices. Le film peut être réalisé en aluminium, argent, ou tout autre matériau dont la réflectance à la longueur d'onde d'excitation est supérieure ou égale à 80%, de préférence supérieure ou égale à 90%, voire à 95%.

Par ailleurs, de manière à limiter la transmission du rayonnement d'excitation jusqu'à la zone active de la photodiode, notamment lorsque le rayonnement incident d'excitation présente un angle d'incidence vis-à-vis du filtre optique se traduisant par une baisse du taux de rejection du rayonnement d'excitation par le filtre, un film d'un matériau absorbant (non représenté) revêt la face des portions isolantes des photodiodes opposée à la face en contact avec les portions semiconductrices. Le film peut être réalisé en or ou tout autre matériau dont l'absorbance à la longueur d'onde d'excitation est supérieure ou égale à 80%, de préférence supérieure ou égale à 90%, voire à 95%.

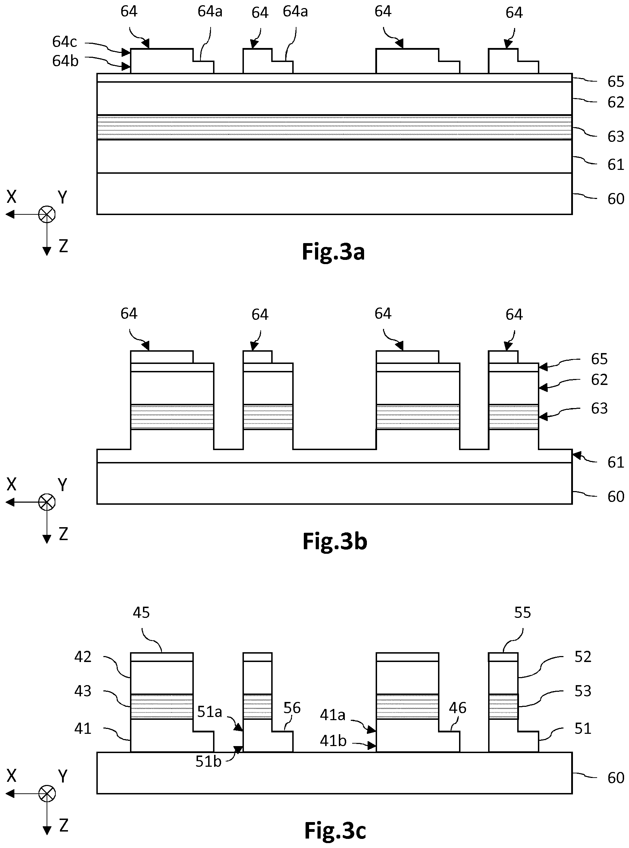

Un exemple de procédé de réalisation d'un dispositif d'émission de lumière selon un autre mode de réalisation est maintenant décrit en référence aux figures 3a à 3h. Cet exemple est similaire à celui décrit dans la demande de brevet FR1456085 déposée le 27/06/2014 dont le texte est considéré comme faisant partie intégrante de la présente description.

En référence à la figure 3a, on réalise, sur un substrat de croissance 60, un empilement formé d'une couche semiconductrice 61 dopée N, d'une couche active 63 comportant des puits quantiques dont au moins un puits quantique dit émissif et au moins un puits quantique dit de détection décrits en référence à la figure 2a intercalés entre des couches barrières, et d'une couche semiconductrice 62 dopée P. On revêt ensuite la surface libre de la couche dopée P d'une couche électriquement conductrice 65, par exemple en aluminium ou en argent. Ces couches empilées sont destinés à former les portions 42, 52 dopées P, les portions 41, 51 dopées N et les zones actives 43, 53 des diodes électroluminescentes et des photodiodes, ainsi que les portions conductrices 45, 55. A noter que la couche 61 dopée N peut comporter une partie fortement dopée N+ recouvrant le substrat, recouverte d'une partie présentant un niveau de dopage inférieur. Les deux parties de la couche dopée N peut être réalisée en un même matériau ou en deux matériaux différents. Par ailleurs, le substrat de croissance peut être en un matériau isolant, par exemple en saphir, ou en matériau semiconducteur, par exemple en silicium, ou à base d'un matériau III-V ou II-VI.

On dépose ensuite des plots structurés 64 de masque dur. Des plots de grandes dimensions latérales sont destinés à la formation des diodes électroluminescentes alors que des plots de dimensions latérales inférieures sont destinés à la formation des photodiodes. Les plots 64 présentent une structure formant un décrochement 64a au niveau d'un flanc latéral. Ainsi, chaque plot 64 comporte une première partie 64b, formant une base qui repose sur la couche conductrice 65, dont les dimensions latérales définissent ultérieurement celles de la seconde partie 41b, 51b des portions 41, 51 dopées N des diodes. Il comporte une seconde partie 64c, qui s'étend à partir de la première partie 64b, dont les dimensions latérales définissent ultérieurement celles de la première partie 41a, 51a des portions dopées N, de la zone active 43, 53 et de la portion 42, 52 dopée P des diodes. Les épaisseurs des deux parties des masques durs sont choisies en fonction de la vitesse de gravure des différents matériaux de l'empilement de couches.

En référence à la figure 3b, on réalise une gravure de l'empilement de la couche conductrice 65, de la couche 62 dopée P, de la couche active 63, et d'une partie de la couche 61 dopée N, à partir de la surface exposée de l'empilement entre les plots 64 de masque dur. La partie 64a formant décrochement des plots de masque dur est également gravée lors de cette étape. La gravure est une gravure sèche, telle qu'une gravure ionique réactive ou une gravure par plasma.

En référence à la figure 3c, on poursuit la gravure à partir de la surface exposée de l'empilement non recouverte par les plots 64 de masque dur. Ainsi, on obtient une pluralité de structures mesa coplanaires formées chacune d'un empilement d'une portion conductrice 45, 55, d'une portion 42, 52 dopée P, d'une zone active 43, 53, et d'une portion 41, 51 dopée N présentant un décrochement 46, 56 entre une première partie 41a, 51a au contact de la zone active et une seconde partie 41b, 51b recouvrant le substrat 60. La première partie 41a, 51a de la portion dopée N présente des dimensions latérales dans le plan (X,Y) inférieures à celles de la seconde partie 41b, 51b de manière à former une surface de décrochement 46, 56. De préférence, les structures mesa destinées à former des diodes électroluminescentes présentent des dimensions latérales supérieures à celles des structures mesa adjacentes destinées à former des photodiodes. Les portions conductrices présentent une surface exposée, c'est-à-dire libre d'éventuels résidus de masque dur.

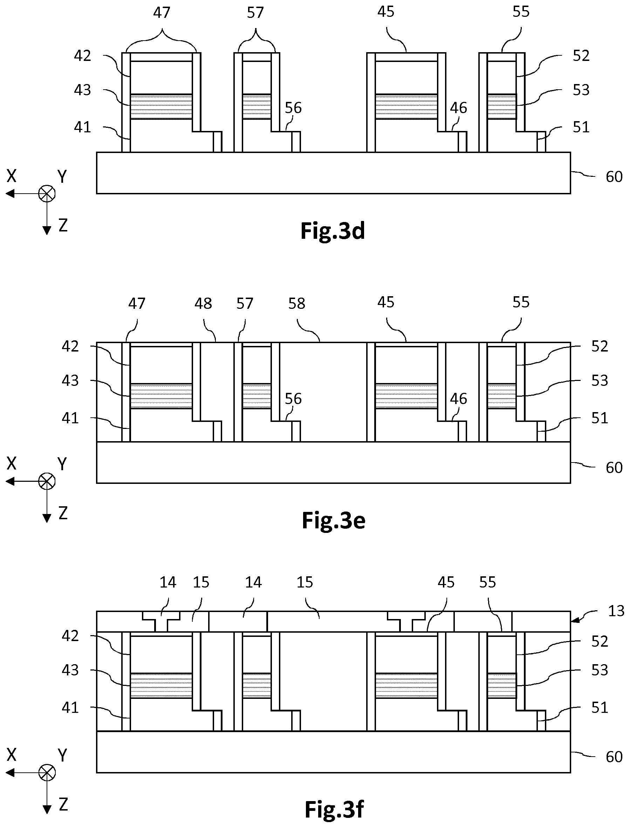

En référence à la figure 3d, on réalise les portions isolantes 47, 57 disposées dans les espaces entre les structures mesa et recouvrant les flancs latéraux des celles-ci, à l'exception des surfaces de décrochement 46, 56. Les portions isolantes peuvent être obtenues par un dépôt conforme d'une couche en un matériau diélectrique, par exemple de SiN d'une épaisseur comprise entre 3nm et 100nm, recouvrant continument les structures mesa et la surface exposée du substrat. On ne conserve ensuite que les portions situées sur les flancs latéraux des structures mesa en réalisant une gravure sèche des portions de la couche diélectrique située entre les structures mesa, sur les surfaces de décrochement et sur la face des portions conductrices.

De manière facultative, on peut réaliser, par des étapes classiques de lithographie, de gravure et de dépôt conforme de type pulvérisation cathodique ou dépôt chimique en phase vapeur, un film en un matériau réfléchissant vis-à-vis de la longueur d'onde d'excitation, par exemple en aluminium ou en argent, recouvrant la surface exposée des portions isolantes qui recouvrent les flancs latéraux des structures mesa destinées à former des diodes électroluminescentes. A titre illustratif, l'épaisseur du film peut être inférieure ou égale à 50nm dans le cas de l'aluminium, ou être inférieure ou égale à 75nm dans le cas de l'argent. On peut également réaliser un film en un matériau absorbant vis-à-vis de la longueur d'onde d'excitation, par exemple en or, recouvrant la surface exposée des portions isolantes qui recouvrent les flancs latéraux des structures mesa destinées à former des photodiodes. A titre illustratif, l'épaisseur du film peut être supérieure ou égale à 100nm dans le cas de l'or. Une gravure sèche est éventuellement effectuée pour exposer à nouveau la surface des portions conductrices, et isoler électriquement les portions conductrices des films réfléchissants ou absorbants par les portions isolantes. Dans le cas où les films réfléchissants et absorbants sont électriquement conducteurs, ils peuvent recouvrir les surfaces de décrochement correspondantes.

En référence à la figure 3e, on forme les éléments de connexion latéraux 48, 58 par remplissage de l'espace situé entre les structures mesa. Pour cela, on réalise un dépôt pleine plaque d'un matériau électriquement conducteur, suivi d'une planarisation mécano-chimique et/ou d'une gravure, par exemple une gravure RIE, de manière à supprimer le matériau conducteur déposé recouvrant les structures mesa et ainsi rendre libre la face supérieure des portions conductrices 45, 55 et celle des portions isolantes 47, 57. La face supérieure obtenue est alors sensiblement plane.

En référence à la figure 3f, on réalise une couche de raccord électrique 13 recouvrant la face supérieure de la structure obtenue à l'issue de l'étape précédente, la couche de raccord est formée d'un matériau diélectrique 15 entourant des éléments de connexion 14 qui s'étendent entre les deux faces opposées de la couche 13 et viennent au contact des portions conductrices 45, 55 et des éléments de connexion latéraux 48, 58. Pour cela, on dépose une couche diélectrique sur la structure obtenue, puis par lithographie et gravure, on définit des cavités destinées à recevoir les éléments de connexion. Ces cavités sont ensuite remplies par un dépôt pleine plaque d'un matériau électriquement conducteur, par exemple de l'aluminium, suivi d'une planarisation mécano-chimique. La couche de raccord présente une face libre sensiblement plane adaptée à un collage par exemple direct avec une puce de commande.

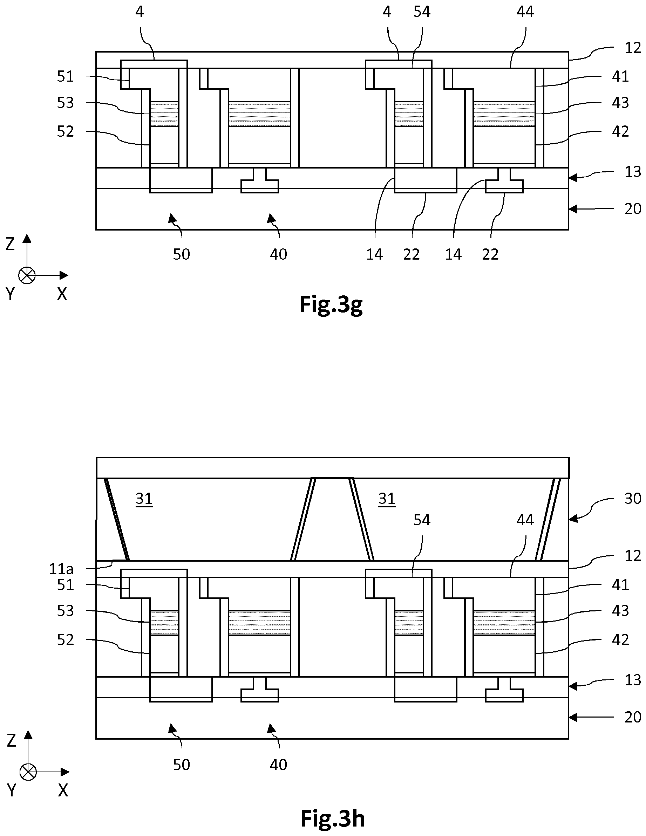

En référence à la figure 3g, on fixe la structure formée sur une puce de commande 20 au niveau de la surface libre de la couche de raccord 13. La puce de commande comporte des portions électriquement conductrices 22 de polarisation venant au contact des éléments de connexion 14 de la couche de raccord 13. La fixation peut notamment être assurée par un collage direct, ou collage par adhérence moléculaire, entre les surfaces métalliques respectives de la puce optoélectronique et de la puce de commande, ainsi qu'entre les surfaces diélectriques respectives des deux puces. Alternativement, une fixation par des microbilles de connexion électriques et/ou par thermocompression peut également être effectuée.

Dans cet exemple, on retire le substrat de croissance 60, par exemple par planarisation mécano-chimique et/ou une gravure sèche, de manière à exposer la face supérieure de la puce optoélectronique comportant les surfaces d'émission 44 et de réception 54 des diodes 40, 50.

On réalise ensuite, par des étapes classiques de lithographie, gravure et dépôt, des filtres optiques 4 recouvrant la surface de réception 54 des photodiodes, par exemple par une alternance de portions de couche de matériaux diélectriques. On recouvre ensuite la face supérieure de la puce optoélectronique et les filtres optiques 4 d'une couche 12 d'un matériau diélectrique que l'on planarise ensuite par exemple de manière mécano-chimique. La face libre de la couche peut être localement structurée de manière à former des motifs en relief disposés en regard des surfaces d'émission et éventuellement des surfaces de réception.

En référence à la figure 3h, on fixe un capot 30 comportant des blocs 31 de matériau à particules photoluminescentes sur la face avant 11a de la puce optoélectronique, de manière à ce que le matériau photoluminescent recouvre la surface d'émission 44 des diodes électroluminescentes et la surface de réception 54 des photodiodes adjacentes. Ici, chaque bloc photoluminescent 31 est en regard d'un pixel comportant une diode électroluminescente et une photodiode adjacente. Les blocs photoluminescents peuvent présenter des longueurs d'onde de luminescence différentes les uns des autres.

On peut ainsi fixer à la puce optoélectronique, par thermocompression ou collage direct, un cadre comportant un maillage d'ouvertures traversantes destinées à recevoir les blocs photoluminescents, puis remplir les ouvertures par un procédé dit additif de dépôt du matériau photoluminescent. Le procédé peut être une impression par jet d'encre, héliographie, sérigraphie, flexographie, revêtement par pulvérisation ou dépôt de gouttes, ou toute autre technique adaptée. La matrice liante peut ensuite être polymérisée, par exemple par un rayonnement ultraviolet.

Des modes de réalisation particuliers viennent d'être décrits. Différentes variantes et modifications apparaîtront à l'homme du métier.

Ainsi, les modes de réalisation décrits précédemment mentionnent une portion dopée N comportant une surface de décrochement et une portion dopée P située en regard de la puce de commande. Les types de conductivité des portions dopées peuvent bien entendu être inversés.

Par ailleurs, certains blocs peuvent ne pas comporter de matériau photoluminescent mais un matériau optiquement inerte, c'est-à-dire n'émettant pas de lumière en réponse à une absorption éventuelle du rayonnement d'excitation, et comportant des particules diffusantes dispersées dans une matrice liante. Les particules diffusantes peuvent présenter une taille moyenne nanométrique, par exemple comprise entre 0,2nm et 1000nm, éventuellement de l'ordre de 5nm à 10nm, ou une taille moyenne micrométrique, par exemple comprise entre 1µm et 50µm, éventuellement de l'ordre de 10µm.

## Revendications

1. Dispositif optoélectronique (1) d'émission de lumière, comprenant :
- au moins une diode électroluminescente (40) présentant une surface d'émission (44), apte à émettre un rayonnement lumineux dit d'excitation ; et
- un matériau photoluminescent (31) qui revêt la surface d'émission (44), le matériau photoluminescent comportant des particules photoluminescentes adaptées à convertir au moins en partie ledit rayonnement lumineux d'excitation au travers de la surface d'émission (44) en un rayonnement lumineux dit de photoluminescence ;
où le dispositif comporte au moins une photodiode (50), adjacente à la diode électroluminescente (40), présentant une surface de réception (54) revêtue par le matériau photoluminescent (31), et adaptée à détecter au moins une partie du rayonnement d'excitation et/ou du rayonnement de photoluminescence provenant du matériau photoluminescent (31) au travers de la surface de réception (54).

2. Dispositif optoélectronique (1) selon la revendication 1, dans lequel la diode électroluminescente (40) et la photodiode (50) présentent chacune une structure mesa, la surface d'émission (44) et la surface de réception (54) étant sensiblement coplanaires.

3. Dispositif optoélectronique (1) selon la revendication 1 ou 2, dans lequel la diode électroluminescente (40) et la photodiode (50) comportent chacune une première portion semiconductrice (41, 51) dopée selon un premier type de conductivité et une seconde portion semiconductrice (42, 52) dopée selon un second type de conductivité opposé au premier type de conductivité, les premières portions et secondes portions semiconductrices étant respectivement sensiblement coplanaires et réalisées en un matériau de même composition.

4. Dispositif optoélectronique (1) selon la revendication 3, dans lequel la première portion semiconductrice dopée (41) de la diode électroluminescente et celle (51) de la photodiode présentent chacune un flanc latéral comportant une surface de décrochement (46, 56) formée par une seconde partie (41b, 51b) de la première portion semiconductrice dopée (41, 51) vis-à-vis d'une première partie (41a, 51a) de celle-ci.

5. Dispositif optoélectronique (1) selon la revendication 4, dans lequel un élément de connexion électrique latéral (48, 58) s'étend entre la diode électroluminescente (40) et la photodiode (50) adjacente, de manière à être au contact électrique avec la surface de décrochement (46, 56) de la première portion semiconductrice dopée (41, 51), l'élément de connexion latéral étant en outre électriquement isolé de la seconde portion semiconductrice dopée (42, 52) et de zones actives (43, 53) situées entre les première (41, 51) et seconde (42, 52) portions semiconductrices dopées par des portions diélectriques (47, 57) recouvrant des flancs latéraux des structures mesa.

6. Dispositif optoélectronique (1) selon l'une quelconque des revendications 3 à 5, dans lequel la diode électroluminescente et la photodiode comportent chacune une zone active (43, 53) située entre les première (41, 51) et seconde (42, 52) portions semiconductrices dopées, les zones actives étant sensiblement coplanaires et réalisées en un matériau de même composition.

7. Dispositif optoélectronique (1) selon la revendication 6, dans lequel les zones actives (43, 53) de la diode électroluminescente et de la photodiode comportent chacune au moins un premier puits quantique (2), ledit premier puits quantique de la zone active (43) de la diode électroluminescente étant adapté à émettre le rayonnement lumineux d'excitation à une longueur d'onde dite d'excitation.

8. Dispositif optoélectronique (1) selon la revendication 7, dans lequel les zones actives (43, 53) de la diode électroluminescente et de la photodiode comportent chacune au moins un second puits quantique (3), ledit puits quantique de la zone active (53) de la photodiode étant adapté à détecter le rayonnement lumineux de photoluminescence.

9. Dispositif optoélectronique (1) selon la revendication 8, dans lequel le second puits quantique (3) est situé entre une première portion semiconductrice (41, 51) dopée de type N et le premier puits quantique (2).

10. Dispositif optoélectronique (1) selon l'une quelconque des revendications 1 à 9, comportant un filtre optique (4) disposé entre le matériau photoluminescent (31) et la surface de réception (54) de la photodiode, le filtre étant adapté à transmettre le rayonnement de photoluminescence et à bloquer une transmission du rayonnement d'excitation.

11. Dispositif optoélectronique (1) selon l'une quelconque des revendications 1 à 10, comportant en outre un dispositif de commande adapté à modifier le rayonnement lumineux d'excitation émis par la diode électroluminescente à partir d'un signal de détection du rayonnement lumineux détecté par la photodiode (50).

12. Dispositif optoélectronique (1) selon l'une quelconque des revendications 1 à 11, comportant des contacts électriques (14) adaptés à polariser la diode électroluminescente et la photodiode, les contacts électriques (14) étant situés au niveau d'une face de la diode électroluminescente et de la photodiode opposée à la surface d'émission (44) et à la surface de réception (54).

13. Procédé de fabrication d'un dispositif optoélectronique (1) d'émission de lumière selon l'une quelconque des revendications précédentes, dans lequel :
i) on réalise au moins une diode électroluminescente (40) présentant une surface d'émission (44) et apte à émettre un rayonnement lumineux dit d'excitation, et au moins une photodiode (50) adjacente présentant une surface de réception (54) ;
ii) on recouvre les surfaces d'émission (44) et de réception (54) d'un matériau photoluminescent (31) comportant des particules photoluminescentes adaptées à convertir au moins en partie ledit rayonnement lumineux d'excitation au travers de la surface d'émission (44) en un rayonnement lumineux dit de photoluminescence.

14. Procédé selon la revendication précédente, dans lequel l'étape i) comporte les sous-étapes dans lesquelles :
a. on réalise un empilement de couches comprenant une première couche semiconductrice dopée (61) et une seconde couche semiconductrice dopée (62) entre lesquelles est interposée une couche active (63) comportant au moins un puits quantique (2) ;
b. on grave l'empilement de couches de manière à former une structure mesa destinée à former une diode électroluminescente (40) et une structure mesa destinée à former une photodiode (50) adjacente, chaque structure mesa étant formée d'un empilement d'une première portion semiconductrice dopée (41, 51), d'une zone active (43, 53) et d'une seconde portion semiconductrice dopée (42, 52), la première portion semiconductrice dopée (41, 51) desdites structures mesa comportant un flanc latéral présentant une surface de décrochement (46, 56) ;
c. on réalise des portions diélectriques (47, 57) recouvrant les flancs latéraux des structures mesa à l'exception des surfaces de décrochement ;
d.on dépose un matériau électriquement conducteur (48, 58) entre les structures mesa, le matériau conducteur étant en contact de la surface de décrochement (46, 56) de la première portion semiconductrice dopée (41, 51) et électriquement isolé par les portions diélectriques (47, 57) de la zone active (43, 53) et de la seconde portion semiconductrice dopée (42, 52).

15. Procédé selon la revendication 14, dans lequel on réalise des éléments de connexion électrique (14) adaptés à polariser en direct la diode électroluminescente (40) et en indirect la photodiode (50) à partir de portions électriquement conductrices (22) de polarisation situées sur une face opposée au matériau photoluminescent (31).

## Patentansprüche

1. Optoelektronische Vorrichtung (1) zur Lichtabgabe, umfassend:
- wenigstens eine Leuchtdiode (40), die eine Emissionsfläche (44) aufweist und in der Lage ist, eine sogenannte Anregungslichtstrahlung zu emittieren; und
- ein photolumineszierendes Material (31), welches die Emissionsfläche (44) bedeckt, wobei das photolumineszierende Material photolumineszierende Partikel umfasst, die geeignet sind, wenigstens einen Teil der Anregungslichtstrahlung, welche die Emissionsfläche (44) durchquert, in eine sogenannte Photolumineszenzstrahlung umzuwandeln;
wobei die Vorrichtung wenigstens eine der Leuchtdiode (40) benachbarte Photodiode (50) umfasst, die eine mit dem photolumineszierenden Material (31) beschichtete Empfangsfläche (54) aufweist und dazu eingerichtet ist, wenigstens einen Teil der Anregungsstrahlung und/oder der von dem photolumineszierenden Material (31) stammenden Photolumineszenzstrahlung durch die Empfangsfläche (54) hindurch zu detektieren.

2. Optoelektronische Vorrichtung (1) nach Anspruch 1, wobei die Leuchtdiode (40) und die Photodiode (50) jeweils eine Mesa-Struktur aufweisen, wobei die Emissionsfläche (44) und die Empfangsfläche (54) im Wesentlichen koplanar sind.

3. Optoelektronische Vorrichtung (1) nach Anspruch 1 oder 2, wobei die Leuchtdiode (40) und die Photodiode (50) jeweils einen ersten halbleitenden Abschnitt (41, 51), der mit einem ersten Leitfähigkeitstyp dotiert ist, und einen zweiten halbleitenden Abschnitt (42, 52), der mit einem zweiten Leitfähigkeitstyp dotiert ist, umfassen, wobei die ersten Abschnitte und zweiten halbleitenden Abschnitte jeweils im Wesentlichen koplanar und aus einem Material mit derselben Zusammensetzung hergestellt sind.

4. Optoelektronische Vorrichtung (1) nach Anspruch 3, wobei der erste dotierte halbleitende Abschnitt (41) der Leuchtdiode und derjenige (51) der Photodiode jeweils eine seitliche Flanke aufweisen, die eine Rücksprungfläche (46, 56) umfasst, die von einem zweiten Teil (41b, 51b) des ersten dotierten halbleitenden Abschnitts (41, 51) gebildet wird, der einem ersten Teil (41a, 51a) desselben gegenüberliegt.

5. Optoelektronische Vorrichtung (1) nach Anspruch 4, wobei sich ein seitliches elektrisches Verbindungselement (48, 58) zwischen der Leuchtdiode (40) und der benachbarten Photodiode (50) erstreckt, derart, dass es sich in elektrischem Kontakt mit der Rücksprungfläche (46, 56) des ersten dotierten halbleitenden Abschnitts (41, 51) befindet, wobei das seitliche Verbindungselement außerdem von dem zweiten dotierten halbleitenden Abschnitt (42, 52) und von aktiven Bereichen (43, 53), die sich zwischen dem ersten (41, 51) und zweiten (42, 52) dotierten halbleitenden Abschnitt befinden, durch dielektrische Abschnitte (47, 57) elektrisch isoliert ist, die seitliche Flanken der Mesa-Strukturen bedecken.

6. Optoelektronische Vorrichtung (1) nach einem der Ansprüche 3 bis 5, wobei die Leuchtdiode und die Photodiode jeweils einen aktiven Bereich (43, 53) umfassen, der sich zwischen dem ersten (41, 51) und zweiten (42, 52) dotierten halbleitenden Abschnitt befindet, wobei die aktiven Bereiche im Wesentlichen koplanar und aus einem Material mit derselben Zusammensetzung hergestellt sind.

7. Optoelektronische Vorrichtung (1) nach Anspruch 6, wobei die aktiven Bereiche (43, 53) der Leuchtdiode und der Photodiode jeweils wenigstens einen ersten Quantentopf (2) umfassen, wobei der erste Quantentopf des aktiven Bereichs (43) der Leuchtdiode dazu eingerichtet ist, die Anregungslichtstrahlung mit einer sogenannten Anregungswellenlänge zu emittieren.

8. Optoelektronische Vorrichtung (1) nach Anspruch 7, wobei die aktiven Bereiche (43, 53) der Leuchtdiode und der Photodiode jeweils wenigstens einen zweiten Quantentopf (3) umfassen, wobei der Quantentopf des aktiven Bereichs (53) der Photodiode dazu eingerichtet ist, die Photolumineszenzstrahlung zu detektieren.

9. Optoelektronische Vorrichtung (1) nach Anspruch 8, wobei sich der zweite Quantentopf (3) zwischen einem ersten n-dotierten halbleitenden Abschnitt (41, 51) und dem ersten Quantentopf (2) befindet.

10. Optoelektronische Vorrichtung (1) nach einem der Ansprüche 1 bis 9, welche ein optisches Filter (4) umfasst, das zwischen dem photolumineszierenden Material (31) und der Empfangsfläche (54) der Photodiode angeordnet ist, wobei das Filter dazu eingerichtet ist, die Photolumineszenzstrahlung zu übertragen und eine Übertragung der Anregungsstrahlung zu blockieren.

11. Optoelektronische Vorrichtung (1) nach einem der Ansprüche 1 bis 10, welche außerdem eine Steuervorrichtung umfasst, die dazu eingerichtet ist, die von der Leuchtdiode emittierte Anregungslichtstrahlung anhand eines Detektionssignals der von der Photodiode (50) detektierten Lichtstrahlung zu modifizieren.

12. Optoelektronische Vorrichtung (1) nach einem der Ansprüche 1 bis 11, welche elektrische Kontakte (14) umfasst, die dazu eingerichtet sind, die Leuchtdiode und die Photodiode vorzuspannen, wobei sich die elektrischen Kontakte (14) auf einer Seite der Leuchtdiode und der Photodiode befinden, die der Emissionsfläche (44) und der Empfangsfläche (54) gegenüberliegt.

13. Verfahren zur Herstellung einer optoelektronischen Vorrichtung (1) zur Lichtabgabe nach einem der vorhergehenden Ansprüche, wobei:
i) wenigstens eine Leuchtdiode (40), die eine Emissionsfläche (44) aufweist und in der Lage ist, eine sogenannte Anregungslichtstrahlung zu emittieren, und wenigstens eine benachbarte Photodiode (50), die eine Empfangsfläche (54) aufweist, hergestellt werden;
ii) die Emissionsfläche (44) und die Empfangsfläche (54) mit einem photolumineszierenden Material (31) bedeckt werden, das photolumineszierende Partikel umfasst, die geeignet sind, wenigstens einen Teil der Anregungslichtstrahlung, welche die Emissionsfläche (44) durchquert, in eine sogenannte Photolumineszenzstrahlung umzuwandeln.

14. Verfahren nach dem vorhergehenden Anspruch, wobei Schritt i) die Teilschritte umfasst, in denen:
a. ein Stapel von Schichten hergestellt wird, der eine erste dotierte halbleitende Schicht (61) und eine zweite dotierte halbleitende Schicht (62) umfasst, zwischen denen eine aktive Schicht (63) eingefügt ist, die wenigstens einen Quantentopf (2) umfasst;
b. der Stapel von Schichten geätzt wird, um eine Mesa-Struktur, die dazu bestimmt ist, eine Leuchtdiode (40) zu bilden, und eine Mesa-Struktur, die dazu bestimmt ist, eine benachbarte Photodiode (50) zu bilden, auszubilden, wobei jede Mesa-Struktur von einem Stapel aus einem ersten dotierten halbleitenden Abschnitt (41, 51), einem aktiven Bereich (43, 53) und einem zweiten dotierten halbleitenden Abschnitt (42, 52) gebildet wird, wobei der erste dotierte halbleitende Abschnitt (41, 51) der Mesa-Strukturen eine seitliche Flanke umfasst, die eine Rücksprungfläche (46, 56) aufweist;
c. dielektrische Abschnitte (47, 57) hergestellt werden, welche die seitlichen Flanken der Mesa-Strukturen mit Ausnahme der Rücksprungflächen bedecken;
d. ein elektrisch leitendes Material (48, 58) zwischen den Mesa-Strukturen aufgebracht wird, wobei sich das leitende Material in Kontakt mit der Rücksprungfläche (46, 56) des ersten dotierten halbleitenden Abschnitts (41, 51) befindet und durch die dielektrischen Abschnitte (47, 57) von dem aktiven Bereich (43, 53) und von dem zweiten dotierten halbleitenden Abschnitt (42, 52) elektrisch isoliert ist.

15. Verfahren nach Anspruch 14, wobei elektrische Verbindungselemente (14) hergestellt werden, die dazu eingerichtet sind, von elektrisch leitenden Vorspannabschnitten (22) aus, die sich auf einer dem photolumineszierenden Material (31) gegenüberliegenden Seite befinden, die Leuchtdiode (40) vorwärts und die Photodiode (50) rückwärts vorzuspannen.

## Claims

1. Optoelectronic light-emitting device (1), including:
- at least one light-emitting diode (40) having an emitting surface (44) adapted to emit so-called excitation luminous radiation; and
- a photoluminescent material (31) that coats the emitting surface (44), the photoluminescent material containing photoluminescent particles adapted to convert said excitation luminous radiation through the emitting surface (44) at least in part into so-called photoluminescence luminous radiation;
where the device includes at least one photodiode (50) adjacent to the light-emitting diode (40), having a receiving surface (54) coated by the photoluminescent material (31), and adapted to detect at least part of the excitation radiation and/or the photoluminescence radiation coming from the photoluminescent material (31) through the receiving surface (54).

2. Optoelectronic device (1) according to Claim 1, in which the light-emitting diode (40) and the photodiode (50) each have a mesa structure, the emitting surface (44) and the receiving surface being substantially coplanar (54).

3. Optoelectronic device (1) according to Claim 1 or 2, in which the light-emitting diode (40) and the photodiode (50) each include a first semiconductor portion (41, 51) doped with a first conductivity type and a second semiconductor portion (42, 52) doped with a second conductivity type opposite the first conductivity type, the first and second semiconductor portions being respectively substantially coplanar and made from a material with the same composition.

4. Optoelectronic device (1) according to Claim 3, in which the first doped semiconductor portion (41) of the light-emitting diode and that (51) of the photodiode each have a lateral flank including a stepped surface (46, 56) formed by a second part (41b, 51b) of the first doped semiconductor portion (41, 51) facing a first part (41a, 51a) thereof.

5. Optoelectronic device (1) according to Claim 4, in which a lateral electrical connection element (48, 58) extends between the light-emitting diode (40) and the adjacent photodiode (50) so as to be in electrical contact with the stepped surface (46, 56) of the first doped semiconductor portion (41, 51), the lateral connection element being further electrically insulated from the second doped semiconductor portion (42, 52) and active zones (43, 53) situated between the first (41, 51) and second (42, 52) doped semiconductor portions by dielectric portions (47, 57) covering lateral flanks of the mesa structures.

6. Optoelectronic device (1) according to any one of Claims 3 to 5, in which the light-emitting diode and the photodiode each include an active zone (43, 53) situated between the first (41, 51) and second (42, 52) doped semiconductor portions, the active zones being substantially coplanar and made from a material with the same composition.

7. Optoelectronic device (1) according to Claim 6, in which the active zones (43, 53) of the light-emitting diode and the photodiode each include at least one first quantum well (2), said first quantum well of the active zone (43) of the light-emitting diode being adapted to emit the excitation luminous radiation at a so-called excitation wavelength.

8. Optoelectronic device (1) according to Claim 7, in which the active zones (43, 53) of the light-emitting diode and the photodiode each include at least one second quantum well (3), said quantum well of the active zone (53) of the photodiode being adapted to detect the photoluminescence luminous radiation.

9. Optoelectronic device (1) according to Claim 8, in which the second quantum well (3) is situated between an N-type first doped semiconductor portion (41, 51) and the first quantum well (2).

10. Optoelectronic device (1) according to any one of Claims 1 to 9, including an optical filter (4) disposed between the photoluminescent material (31) and the receiving surface (54) of the photodiode, the filter being adapted to transmit the photoluminescence radiation and to block transmission of the excitation radiation.

11. Optoelectronic device (1) according to any one of Claims 1 to 10, further including a control device adapted to modify the excitation luminous radiation emitted by the light-emitting diode on the basis of a detection signal of the luminous radiation detected by the photodiode (50).

12. Optoelectronic device (1) according to any one of Claims 1 to 11, including electrical contacts (14) adapted to bias the light-emitting diode and the photodiode, the electrical contacts (14) being situated at the level of a face of the light-emitting diode and of the photodiode opposite the emitting surface (44) and the receiving surface (54).

13. Method of manufacturing an optoelectronic light-emitting device (1) according to any one of the preceding claims, comprising the steps of:
i) producing at least one light-emitting diode (40) having an emitting surface (44) and able to emit so-called excitation luminous radiation and at least one adjacent photodiode (50) having a receiving surface (54);
ii) covering the emitting surface (44) and the receiving surface (54) with a photoluminescent material (31) containing photoluminescent particles adapted to convert said excitation luminous radiation through the emitting surface (44) at least in part into so-called photoluminescence luminous radiation.

14. Method according to the preceding claim, in which the step i) includes the substeps of:
a. producing a stack of layers including a first doped semiconductor layer (61) and a second doped semiconductor layer (62) between which is disposed an active layer (63) including at least one quantum well (2);
b. etching the stack of layers so as to form a mesa structure intended to form a light-emitting diode (40) and a mesa structure intended to form an adjacent photodiode (50), each mesa structure being formed of a stack of a first doped semiconductor portion (41, 51), an active zone (43, 53) and a second doped semiconductor portion (42, 52), the first doped semiconductor portion (41, 51) of said mesa structures including a lateral flank having a stepped surface (46, 56);
c. producing dielectric portions (47, 57) covering the lateral flanks of the mesa structures with the exception of the stepped surfaces;
d. depositing an electrically conductive material (48, 58) between the mesa structures, the conductive material being in contact with the stepped surface (46, 56) of the first doped semiconductor portion (41, 51) and electrically insulated by the dielectric portions (47, 57) from the active zone (43, 53) and the second doped semiconductor portion (42, 52).

15. Method according to Claim 14, in which electrical connection elements (14) are produced adapted to forward bias the light-emitting diode (40) and to reverse bias the photodiode (50) from electrically conductive biasing portions (22) situated on a face opposite the photoluminescent material (31).
